(19) Europäisches Patentamt
European Patent Office
Office européen des brevets

(11) **EP 2 415 728 B1**

(12) **EUROPEAN PATENT SPECIFICATION**

(45) Date of publication and mention
of the grant of the patent:
**10.05.2017 Bulletin 2017/19**

(51) Int Cl.:
**C04B 35/111** (2006.01)  **C04B 35/44** (2006.01)
**H01L 23/13** (2006.01)  **H01L 23/14** (2006.01)
**H01L 23/373** (2006.01)

(21) Application number: **10758893.1**

(22) Date of filing: **02.04.2010**

(86) International application number:
**PCT/JP2010/056084**

(87) International publication number:
**WO 2010/114126 (07.10.2010 Gazette 2010/40)**

(54) **SINTERED CERAMIC AND SUBSTRATE COMPRISING SAME FOR SEMICONDUCTOR DEVICE**

GESINTERTE KERAMIK UND SUBSTRAT DAMIT FÜR EINE HALBLEITERVORRICHTUNG

CÉRAMIQUE FRITTÉE ET SUBSTRAT LA COMPRENANT POUR DISPOSITIF À SEMI-CONDUCTEURS

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **03.04.2009 JP 2009091517**

(43) Date of publication of application:
**08.02.2012 Bulletin 2012/06**

(73) Proprietor: **Sumitomo Metal (SMI) Electronics Devices Inc.**
**Yamaguchi 759-2212 (JP)**

(72) Inventors:
• **NAGAHIRO, Masanori**
  **Mine-shi**
  **Yamaguchi 759-2212 (JP)**
• **OOGAMI, Jyunji**
  **Mine-shi**
  **Yamaguchi 759-2212 (JP)**
• **KOMATSU, Hiroyuki**
  **Toyota-shi,**
  **Aichi 470-1206 (JP)**

(74) Representative: **Kuhnen & Wacker**
**Patent- und Rechtsanwaltsbüro**
**Prinz-Ludwig-Straße 40A**
**85354 Freising (DE)**

(56) References cited:
**EP-A1- 0 727 818      EP-A2- 1 510 509**
**JP-A- 4 021 564       JP-A- 8 195 450**
**JP-A- H04 132 660     JP-A- 2007 269 524**

EP 2 415 728 B1

## Description

### Technical Field

The present invention relates to a ceramic sintered member used for a semiconductor device substrate used for a power transistor module or the like, and the present invention particularly relates to a DBOA substrate (Direct Bonding of Aluminum Substrate) equipped with an aluminum plate on the surface of a ceramic substrate, or relates to a DBOC substrate (Direct Bonding of Copper Substrate) equipped with a copper plate on the surface of a ceramic substrate, formed from a ceramic sintered member.

### Background Art

A substrate used for a power transistor device substrate requires excellent thermal conductivity and must be provided with high mechanical strength. Ceramic substrates are used as insulators that satisfy such conditions. EP 1 510 509 describes alumina/zirconia ceramics and a method of producing it. Generally the ceramic substrate is an alumina ceramic substrate containing alumina as a main ingredient, aluminum nitride containing aluminum nitride as a main ingredient, or the like. Although among such substrates aluminum nitride substrates are known to have excellent heat dissipation, such ceramic substrates have a problem of high cost, which makes the use of such substrates difficult. On the other hand, ceramic substrates made from just alumina are inexpensive, but such ceramic substrates have had a problem of inferior heat dissipation.

In order to handle such problems, several inventions have been disclosed that substitute zirconium for part of the powder material of an alumina ceramic and further add materials such as yttria, calcia, magnesia, or the like, thereby making a ceramic substrate that has increased mechanical strength as well as high heat dissipation and low cost.

Patent Citation 1 is titled "Semiconductor Device Substrate" and discloses an invention relating to a semiconductor device substrate suitable for a power transistor module or the like.

The invention disclosed in Patent Citation 1 is characterized in that, in a semiconductor device substrate directly bonding a copper plate to at ceramic substrate, the ceramic substrate is formed from a ceramic sintered member that has alumina as a main ingredient and further includes zirconia.

According to the invention disclosed by Patent Citation 1 configured in this manner, zirconia is added to alumina and is sintered at a high temperature to form a ceramic used as the ceramic substrate of a DBOC substrate. This ceramic substrate is capable of greatly increased mechanical strength in comparison to the conventional ceramic substrate constituted by alumina alone. Thus, it becomes possible in practice to use a thin ceramic substrate, and a DBOC substrate is obtained that has high heat dissipation as a substrate for a semiconductor device. In particular, this ceramic substrate can be used as a substrate for a power transistor module or the like and, thus, this invention has the effect of being able to contribute greatly to increasing the electrical current capacity and the miniaturization of semiconductor devices.

Moreover, Patent Citation 2 is titled "Semiconductor Device Substrate" and discloses an invention relating to an insulating substrate, of a power transistor module or the like, for a semiconductor device that carries a semiconductor chip by soldering or the like of the semiconductor chip to the insulating substrate.

The invention disclosed in Patent Citation 2 is characterized by manufacture from a ceramic sintered member produced by using alumina as a main ingredient, adding zirconia, and further adding at least 1 type of additive selected from the group including yttria, calcia, magnesia, and ceria.

According to the invention having this configuration and disclosed in Patent Citation 2, a ceramic is used as a CBC (Ceramic Bonding Copper) ceramic substrate that is produced by high temperature sintering of alumina to which has been added zirconia as well as an additive such as yttria, calcia, magnesia, or ceria. Thus, mechanical strength can be increased greatly in comparison to the conventional substrate manufactured from alumina alone or from aluminum nitride. Thus, it becomes possible in practice to use a thinner ceramic substrate, and by this means, a CBC is obtained that has high heat dissipation as a substrate for semiconductor devices, and use is especially possible for substrates such as the board of a power transistor module or the like. Therefore, it is possible to miniaturize semiconductor devices, to lower cost, and to increase electrical current capacity.

In particular, within the alumina weight proportion range of 70% to 100%, the zirconia weight proportion range of 0% to 30%, and the additive (selected from among yttria, calcia, magnesia, and ceria) total weight proportion range of 0.02% to 2%, it is possible to obtain a ceramic substrate that has a bending strength and high thermal conductivity that are excellent in practice. The obtained ceramic substrate is excellent from the standpoints of strength, insulation ability, thermal conductivity and low cost as a substrate used for semiconductor devices.

Furthermore, Patent Citation 3 is titled "Semiconductor Device" and discloses an invention relating to a semiconductor device called a "power transistor module" containing in a case a circuit board carrying a semiconductor element and used for a so-called converter and inverter of a switching electrical power supply device, a constant voltage constant frequency controller (CVCF), a variable voltage variable frequency electrical power supply device (VVVF), or the like.

In particular, this Patent Citation 3 discloses an invention relating to a substrate (CBC substrate, i.e., Ceramic Bonding Copper) formed by directly bonding together a sheet-like copper plate to a ceramic substrate (insulation core plate) for an insulating substrate for carrying a semiconductor by soldering attachment or the like of the semiconductor element.

This citation will be explained further using the reference numerals mentioned within the citation. The CBC (Ceramic Bonding Copper) substrate 2 used for the power transistor module that is the invention disclosed in the Patent Citation 3 is produced by direct bonding of the sheet-like copper plates 2b and 2c to the front and backside faces of the ceramic substrate 2a by use of a method such as the direct bond copper method. The circuit pattern is formed in the main face side copper plate 2c. The ceramic substrate 2a is especially a high temperature sintered ceramic formed using alumina as a main ingredient and then adding thereto zirconia as well as an additive agent, i.e., 0.1 to 2 wt% yttria, 0.02 to 0.5 wt% calcia, 0.02 to 0.4 wt% magnesia, and 0.02 to 0.5 wt% ceria.

According to the invention disclosed in Patent Citation 3, it is possible to greatly increase mechanical strength in comparison to the conventional substrate made from alumina alone or from aluminum nitride. Thus, it becomes possible in practice to use a thinner ceramic substrate and, therefore, to obtain a CBC substrate that has high heat dissipation as a substrate for semiconductor devices. In particularly, by application of this ceramic substrate to the substrate of a power module transistor or the like, semiconductor device miniaturization, cost reduction, and a great increase of electrical current capacity become possible. It is possible to increase the degree of integration of semiconductor devices by increasing the size of the substrate. Due to the alleviation of stress, the lead part can be formed without a bent part so that the device can be made thinner. Also due to the ability to eliminate a structure that raises the insulating part of the copper plate, it is possible to lower cost by the elimination of processing.

In particular, when the alumina weight proportion is in the range of 70% to 100%, when the zirconia weight proportion is in the range of 0% to 30%, and when the additive (selected from among yttria, calcia, magnesia, and ceria) total weight proportion range is 0.02% to 2%, it is then possible to obtain a ceramic substrate that has a bending strength and high thermal conductivity that are excellent in practice, and the above described effects become remarkable.

In addition, Patent Citation 4 is titled "High-toughness Ceramic Sintered Member Excellent in Thermal Stability and Its Production" and discloses a highly tough ceramic sintered member having extremely high strength and simultaneously having remarkably excellent thermal stability, and this citation discloses a method for manufacture of such a ceramic sintered member.

The invention disclosed in Patent Citation 4 is characterized by use of a $ZrO_2$ powder material including $Y_2O_3$ and $CeO_2$ as stabilization agents and by addition of 1 to 70 parts by weight of a second ingredient powder (i.e., alumina, spinel, mullite, or the like). This mixture is ground and blended to obtain a mixed powder. The mixed powder is subjected to hot press treatment or hot hydrostatic press treatment at a temperature of 1100°C to 1600°C.

According to the invention disclosed in Patent Citation 4 in this manner, zirconia that is partially tetragonally stabilized by use mainly of a material that includes $Y_2O_3$ and $CeO_2$ as a stabilizer agent (where the concentration of $Y_2O_3$ is at least 1 mol percent), and the ceramic also is formed from the second ingredient (dispersion ingredient) as one type or two or more types selected from among $Al_2O_3$, $MgO.Al_2O_3$ (spinel), and $3Al_2O_3 \cdot 2SiO_2$ (mullite). This ceramic is produced as a compressed sintered member by a method such as the hot press method, hot hydrostatic press method, or the like. Therefore, the ceramic is extremely strong and has remarkably excellent thermal stability. That is, this is a highly tough ceramic sintered member that has extremely little determination of strength and toughness due to thermal history. This type of zirconia based sintered member is unlike any previous zirconia based sintered member. Furthermore, compression sintering has the unexpected and remarkable effect of a 1.5-fold increase in strength in comparison to the normal ceramic sintered at normal pressure.

Moreover, when the highly tough ceramic sintered member having excellent thermal stability disclosed in Patent Citation 4 is used as a slide member, wear resistance is obtained that is about 10 times or much better than that of a 3 mol $Y_2O_3$ partially stabilized zirconia sintered member. The invention disclosed in Patent Citation 4 improves the hardness of the partially stabilized zirconia sintered member in this manner and had greatly improved wear resistance. By further addition of the second ingredient as a main dispersion ingredient, mechanical properties are excellent (i.e., hardness, strength, creep, or the like) in comparison to the conventional zirconia sintered member at high temperature.

The invention disclosed in Patent Citation 4 has excellent properties at normal temperature and high temperature in this manner. Therefore, this ceramic contributes greatly to the application, practical use, and improvement of function of wear resistant ceramic screws used for injection molding of thermoplastic resins or ceramics, hot extrusion dies (for brass rods, copper tubing walls, or the like), gas turbine parts, internal combustion engine parts (for diesel engine parts or the like), pump parts, industrial cutters, cutting tools, grinding machine parts, slide members, artificial bones, artificial teeth, bridge core material of artificial teeth formed by ceramic molding, artificial tooth roots, mechanical tools (such as gauges or the like), solid electrolytes, or the like.

**Early Technology Citations**

**Patent Citations**

Patent Citation 1: Unexamined Laid-open Patent Application No. H7-38014
Patent Citation 2: Unexamined Laid-open Patent Application No. H8-195450
Patent Citation 3: Unexamined Laid-open Patent Application No. H8-195458
Patent Citation 4: Unexamined Laid-open Patent Application No. H6-263533
Patent Citation 5: EP 1 510 509

**Summary of the Invention**

**Problem to be Solved by the Invention**

The invention disclosed in Patent Citation 1 does not require zirconia that is partially stabilized by solid solution of a stabilization agent (such as yttria ($Y_2O_3$) or the like) in the crystal as the powder material. Therefore, difficulty of forming a tetragonal phase of 80 to 100 percent of the zirconia crystals within the ceramic sintered member has been a problem for the invention of Patent Citation 1. Moreover, the invention of Patent Citation 1 has had a problem of the difficulty of lowering the sintering temperature of the ceramic sintered member.

Moreover, when zirconia and yttria are used as the powder material, due to the lack of an efficient reaction between the zirconia and yttria during sintering and the lack of sufficient partial stabilization, the invention of Patent Citation 1 has had a problem in that it is particularly difficult to make 80 to 100 percent of the zirconia crystals in the ceramic sintered member assume the tetragonal phase.

That is, when the relative proportion of the monoclinic phase of the zirconia crystals within the ceramic sintered member after sintering is high, part of the monoclinic phase transits to the tetragonal phase during use of the ceramic sintered member at high temperature, and volume of the zirconia crystals decreases. Furthermore, when the ceramic sintered member is subjected to thermal cycling, defects accumulate in the ceramic sintered member, and mechanical strength may be finally lowered.

Moreover, even when magnesia is not added as an essential material to the powder material of the invention disclosed in Patent Citation 1, there has been a problem in that sufficient lowering of the sintering temperature of the ceramic sintered member is difficult.

When the sintering temperature of the ceramic sintered member can not be sufficiently lowered, and when multiple ceramic moldings are stacked together and sintered simultaneously, the alumina or ceramic powder used as top dressing (for prevention of the fusing together of the individual ceramic moldings) may melt, become attached, and fuse together the individual ceramic moldings. If this happens, there is a problem in that voids are generated when a copper or aluminum plate is provided on the surface of the produced ceramic sintered member, and there is a high risk of the generation of defective products.

Moreover, when magnesia is not included as an essential powder material, spinel crystals are not generated in the ceramic sintered member during sintering and, thus, there is a problem in that wettability with the Cu-O eutectic liquid phase at the interface during attachment of the copper plate declines, the rate of generation of voids increases, and defective products are readily produced.

That is, during production of a large sized DBOC substrate using the invention disclosed in Patent Citation 1, there has been a problem of an inability to secure high mechanical reliability or high quality.

The inventions disclosed in Patent Citation 2 and Patent Citation 3, similarly to the above described Patent Citation 1, do not require use of partially stabilized zirconia.

Moreover, the inventions disclosed in Patent Citation 2 and Patent Citation 3 do not necessarily select yttria and magnesia as necessary powder materials.

Especially when yttria and magnesia are added to alumina and zirconia, it is difficult to sufficiently partially stabilize the zirconia, which isn't partially stabilized by efficiently reacting the zirconia and yttria. Therefore, obtaining 80 to 100 percent of the zirconia crystals within the ceramic sintered member in the tetragonal phase is difficult. Therefore, there has been a problem in that obtaining a thermal expansion coefficient of 8.0 to 9.0 ppm/K is difficult for the produced ceramic sintered member. Patent Citation 1 has a similar problem. Furthermore, when the zirconia powder material is not partially stabilized, it is difficult to lower the ceramic sintering temperature.

Moreover, especially when yttria is added to the alumina and zirconia, and when magnesia is not added, the sintering temperature reduction effect is insufficient, or the lowering of the void generation rate during attachment of the copper plate is not realized and, thus, there are problems similar to those of the Patent Citation 1.

As disclosed in Patent Citation 4, yttria ($Y_2O_3$) and ceria ($CeO_2$) are used as main ingredients for zirconia that is partially stabilized, alumina or spinel are included as subsidiary ingredients at a weight basis concentration of 1 to 70 percent, and the ceramic sintered member is disclosed as having at least 50 percent of the zirconia crystals in the ceramic sintered member as the tetragonal crystal phase. However, when this ceramic is used as a DBOC substrate, there is neither disclosure nor suggestion of details of technology for prevention or suppression of the occurrence of voids at the interface between the copper and the ceramic sintered member surface. Therefore, by referring to Patent Citation 4, it wouldn't be possible to manufacture a power module using a DBOC substrate that has few generated voids.

Moreover, the ceramic sintered member disclosed in Patent Citation 4 contains zirconia as a main ingredient and, thus, this ceramic sintered member has had a problem of having low thermal conductivity and being inappropriate as a heat dissipating substrate used for a power module.

**Means to Solve the Problem**

The above problems are solved by the ceramic sintered member according to claim 1. The partially stabilized zirconia included in the powder material according to the invention configured in the above described manner causes a great increase in the proportion of the tetragonal crystal phase in the zirconia crystals within the ceramic sintered member mentioned in claim 1, and the partially stabilized zirconia causes a lowering of the temperature of sintering of the invention according to claim 1. More specifically, the sintering temperature of the invention according to claim 1 is lowered below 1,600°C.

Moreover, the magnesia included in the powder material causes a lowering of the temperature of sintering of the invention according to claim 1. More specifically, the sintering temperature of the invention according to claim 1 is lowered below 1,600°C. Furthermore, the magnesia causes the generation of spinel crystals in the ceramic sintered member according to claim 1, and the magnesia causes an increase of the grain boundary strength of the crystal grains constituting the ceramic sintered member according to claim 1. The spinel crystals cause an increase of the wettability of the Cu-O eutectic phase during attachment of the copper plate to the surface of the ceramic sintered member mentioned in claim 1.

Furthermore, by setting the content of the partially stabilized zirconia in the powder material within the range of 1 to 30 percent by weight, marked lowering of the thermal conductivity of the ceramic sintered member mentioned in claim 1 is suppressed.

Moreover, due to setting of the content of magnesia in the range of 0.05 to 0.50 percent by weight, generation of an excess of spinel crystals and a great lowering of the thermal conductivity of the ceramic sintered member of claim 1 are suppressed.

Moreover, due to lowering of temperature of sintering of the ceramic sintered member according to claim 1 due to addition of the magnesia and the partially stabilized zirconia, it is possible to form the ceramic sintered member according to claim 1 as a dense sintered member, and this has the effect of increasing thermal conductivity of the ceramic sintered member according to claim 1. Furthermore, lowering of the sintering temperature of the ceramic sintered member according to claim 1 also has the effect of suppressing swelling growth of the zirconia crystal grains in the ceramic sintered member after sintering. Although zirconia crystals have poor wettability with the zirconia crystals with the Cu-O eutectic phase, having little active growth and swelling of the zirconia crystal grains in the ceramic sintered member after sintering has the effect of increasing wettability with the Cu-O eutectic phase when the copper plate is attached to the surface of the ceramic sintered member according to claim 1.

In addition, forming 80 to 100 percent of the zirconia crystals in the ceramic sintered member according to claim 1 as the tetragonal crystal phase has the effect of increasing bending strength of the ceramic sintered member according to claim 1 and making the thermal expansion coefficient 8.0 to 9.0 ppm/K.

The ceramic sintered member according to a second aspect of the invention is the ceramic sintered member according to claim 1, where the ceramic sintered member after sintering includes spinel crystals.

The spinel crystals in the invention configured in the above described manner have the effect of increasing wettability with the Cu-O eutectic phase during attachment of the copper plate to the surface of the ceramic sintered member according to the second aspect of the invention.

Moreover, the invention according to the second aspect of the invention has an effect that is similar to the effect of the invention according to claim 1.

The ceramic sintered member of the invention according to a third aspect of the invention is the ceramic sintered member according to claim 1, where the silica is added to the powder material during production of the ceramic sintered member, and the upper limit of the added amount of this silica is 1 percent by weight relative to the entire powder material.

In addition to having an effect similar to that of the invention according to claim 1, the invention configured in the above described manner, in the same manner as the invention according to claim 1, has the effect of increasing wettability of the Cu-O eutectic phase during attachment of the copper plate to the surface of the ceramic sintered member according to the third aspect of the invention, in a manner similar to the effect of above mentioned spinel crystals.

As the amount of spinel crystals generated in the ceramic sintered member increases, wettability with the Cu-O eutectic phase increases during attachment of the copper plate, and conversely, and the suppression of the generation of voids at the interface with the copper plate increases. Conversely, when the generated amount of the spinel crystals is high, thermal conductivity of the ceramic sintered member used as a DBOC substrate insulator declines.

Therefore, per the invention according to the third aspect of the invention, by addition of silica separately to the powder material to cause an improvement of wettability with the Cu-O eutectic phase in the same manner as that due to spinel crystals, the increase of wettability of the Cu-O eutectic phase is greatly increased.

The lowering of thermal conductivity of the invention according to the third aspect of the invention is limited by setting the upper limit of the added amount of the silica in the entire powder material to 1 percent by weight.

In addition to the above mentioned effect, silica causes an increase of insulation resistance of the ceramic sintered member produced by sintering the powder material that includes partially stabilized zirconia. Oxygen defects are present in the zirconia crystal lattice of partially stabilized zirconia, and electrical conductivity arises due to movement of oxygen ions through such defects. For this reason, a ceramic sintered member produced from a powder material containing partially stabilized zirconia is electrically conductive due to these oxygen defects, which results in a problem of low insulation resistance. However, silica has the property of impeding movement of the oxygen ion, so that the invention according to the third aspect of the invention has the effect of suppressing the lowering of insulation resistance.

The ceramic sintered member that is the invention according to claim 2 is the ceramic sintered member according to claim 1, where average grain size of the zirconia crystals in this ceramic sintered member is within the range of 0.1 to 1.5 $\mu$m.

The invention configured in the above described manner, in addition to having an effect similar to that of the invention according to claim 1, increases wettability with the Cu-O eutectic phase during attachment of the copper plate to the surface of the ceramic sintered member according to claim 2 due to the average size of the zirconia crystals within the ceramic sintered member according to claim 2 being within the range of 0.1 to 1.5 $\mu$m.

The semiconductor device substrate that is the invention according to claim 3 is a semiconductor mounting substrate including a ceramic sintered member and a copper or aluminum plate bonded to at least part of the front face and backside face; powder material used during production of the ceramic body including alumina as a main ingredient and further including as subsidiary ingredients partially stabilized zirconia and magnesia; content of the partially stabilized zirconia being 1 to 30 percent by weight relative to the entire powder material; content of the magnesia relative to the entire powder material being within a range 0.05 to 0.50 percent by weight; mole fraction of yttria in the partially stabilized zirconia being within a range of 0.015 to 0.035; and 80 to 100 percent of the zirconia crystals included in the ceramic sintered member being in the tetragonal crystal phase.

The invention having the above described configuration, in other words, provides copper plate or aluminum plate on at least part of the front face and backside face of the ceramic sintered member according to claim 1. Therefore, the ceramic sintered member of the invention according to claim 3 has effects that are the same as those of the ceramic sintered member according to claim 1. In addition, the copper plate or aluminum plate reinforces the ceramic sintered member, forms interconnect wiring supplying electrical power to the semiconductor element mounted on the ceramic sintered member, or acts as a heat dissipater.

Moreover, the thermal expansion coefficient of the ceramic sintered member is as high as 8.0 to 9.0 ppm/K in comparison to the ceramic produced by the conventional method (for example, as in Patent Citation 1). This has the effect of lessening the thermal expansion coefficient differential between ceramic sintered member and the copper plate or aluminum plate. This has the effect of alleviating thermal stress at the interface with the copper plate or aluminum plate.

In particular, when the copper plate is attached to the surface of the ceramic sintered member, due to addition of magnesia to the powder material used during the production of the ceramic sintered member, spinel ($MgO-Al_2O_3$) crystals are generated in the ceramic sintered member after sintering, and this has the effect of increasing wettability with the Cu-O eutectic phase formed at the surface of the copper plate. This has the effect of suppressing the generation of voids at the interface with the ceramic sintered member during attachment of the copper plate to the surface of the ceramic sintered member.

In particular, when an aluminum plate is used, deformation readily occurs due to softness in comparison to copper plate, and such an aluminum plate is lightweight. Thus, when the semiconductor device substrate mentioned in claim 3 is affected by heat, this has the effect of suppressing the occurrence of the damage and cracks in the ceramic sintered member that result from thermal stress generated at the interface between the ceramic sintered member and the aluminum plate.

The semiconductor device substrate according to a fourth aspect of the invention is the semiconductor device substrate mentioned in claim 3, where the ceramic sintered member after sintering includes spinel crystals.

The invention having the above described composition attaches a copper plate or an aluminum plate to at least one part of the front face and backside face of the ceramic sintered member according to the second aspect of the invention.

Therefore, the invention according to the fourth aspect of the invention had effects that combine the effects of the inventions mentioned respectively in claim 3 and according to the second aspect of the invention.

The semiconductor device substrate according to a fifth aspect of the invention is the semiconductor device substrate mentioned in claim 3, where silica is added to the powder material during production of the ceramic sintered member, and the upper limit of the added amount of this silica is 1 percent by weight relative to the total amount of the powder material.

The invention having the above described composition attaches copper plate or aluminum plate to at least one part of the front face and backside face of the ceramic sintered memberaccording to the third aspect of the invention.

Therefore, the invention according to the fifth aspect of the invention has effects that combine the effects of the inventions mentioned respectively in claim 3 and according to the third aspect of the invention.

The semiconductor device substrate that is the invention according to a sixth aspect of the invention is the semiconductor device substrate mentioned in claim 3, where average size of the zirconia crystals in the ceramic sintered member is within the range of 0.1 to 1.5 $\mu$m.

The invention having the above described composition attaches copper plate or aluminum plate to at least one part of the front face and backside face of the ceramic sintered member mentioned in claim 2.

Therefore, the invention according to the sixth aspect of the invention has effects that combine the effects of the inventions mentioned respectively in claim 3 and claim2.

Effect of the Invention

According to the ceramic sintered member of the invention (especially the ceramic sintered members mentioned respectively in claim 1 and according to the second aspect of the invention), the thermal expansion coefficient of the ceramic sintered member after sintering can be made 8.0 to 9.0 ppm/K. As a result, the thermal expansion coefficient of the ceramic sintered member of the present invention can approach that of the copper plate or aluminum plate. Thus, when the copper plate or aluminum plate is attached to the ceramic sintered member of the present invention, this has the effect of making possible alleviation of thermal stress generated at the interface with the copper plate or aluminum plate.

Moreover, the ceramic sintered member of the present invention has high thermal conductivity, a high thermal expansion coefficient, high mechanical strength, and has a surface with high wettability with respect to the Cu-O eutectic phase. Therefore, the ceramic sintered member of the present invention is particularly suitable as an insulator used as a DBOC substrate.

Use of the ceramic sintered member of the present invention has the effect of making it possible to provide a large sized DBOC substrate or DBOA substrate having higher quality than before.

The invention according to the third aspect of the invention has an effect that is the same as that of the invention according to claim 1.

Furthermore, in comparison to the case when only spinel crystals are present in the ceramic sintered member, this has the effect of being able to greatly increase wettability with the Cu-O eutectic phase at the surface of the ceramic sintered member according to the third aspect of the invention.

As a result, it is possible to increase the void generation rate reduction effect at the interface between the ceramic sintered member and the copper plate during attachment of copper plate to the surface of the ceramic sintered member according to the third aspect of the invention.

Therefore, this has the effect of making possible an increase of product yield.

In addition to the above described effects, the addition of silica has the effect of increasing insulation resistance of the ceramic sintered member produced by sintering the powder material containing the partially stabilized zirconia.

The invention mentioned in claim 2, in addition to effects that are the same as those of the invention mentioned in claim 1, reduces the average size of zirconia crystals in the ceramic sintered member mentioned in claim 2. Therefore, this has the effect of making possible an increase of wettability with the Cu-O eutectic phase during attachment of copper plate to the surface of the ceramic sintered member mentioned in claim 2.

This has the effect of lowering the occurrence of voids at the interface between the ceramic sintered member and the copper plate during attachment of the copper plate to the ceramic sintered member mentioned in claim 2 and has the effect of making possible an increase of product yield.

The invention mentioned in claim 3, in addition to effects that are the same as those of the invention mentioned in claim 1, increases mechanical strength and heat dissipation, and also has the effect of making it possible to provide a large sized semiconductor device substrate that has high quality. Moreover, due to the ability to increase quality by the invention mentioned in claim 3, this invention has the effect of making possible an increase of productivity. Moreover, this result has the effect of making possible a reduction of the production cost of the semiconductor device substrate mentioned in claim 3.

The invention according to the fourth aspect of the invention has effects that combine the respective effects of the inventions mentioned in claim 3 and according to the second aspect of the invention.

The invention according to the fifth aspect of the invention has effects that combine the respective effects of the inventions mentioned in claim 3 and according to the third aspect of the invention.

The invention according to the sixth aspect of the invention has effects that combine the respective effects of the inventions mentioned in claim 3 and claim2.

Brief Description of the Drawings

[FIG. 1] This is a flowchart showing the method of production of the ceramic sintered member of Example 1.

[FIG. 2] This is a graph showing the change of bending strength and thermal conductivity as the added amount of partially stabilized zirconia is changed during production of the ceramic sintered member of Example 1.

[FIG. 3] This is a graph showing the relationship between sintering temperature and sintered density while the added amount of partially stabilized zirconia is changed during production of the ceramic sintered member of Example 1.

[FIG. 4] This is a graph showing the relationship between sintering temperature and sintered density while changing the mole fraction of yttria in the partially stabilized zirconia included in the powder material.

[FIG. 5] This is a graph showing the relationship between sintering temperature and sintered density while changing the added amount of magnesia during production of the ceramic sintered member of Example 1.

[FIG. 6] This is a graph showing the change of thermal expansion coefficient as temperature is raised for a ceramic formed from just alumina, for the ceramic sintered member of a conventional example, and for the ceramic sintered member according to Example 1.

[FIG. 7] This is an x-ray diffraction chart of the ceramic sintered member according to Example 1.

[FIG. 8] Here (a) is a cross-sectional drawing of the semiconductor device substrate according to Example 2, and (b) is a cross-sectional drawing of a semiconductor device using this semiconductor device substrate.

[FIG. 9] This is a cross-sectional drawing showing sample arrangement during manufacture of a semiconductor device substrate sample.

**Reference Numerals**

1      ceramic sintered member
2      semiconductor device substrate
3      ceramic substrate
4      copper plate
5      junction material
6      semiconductor chip
7      bonding wire
8      heat sink
9      semiconductor device
10     semiconductor device substrate sample
11     mesh material

**Description of the Preferred Embodiment**

A ceramic sintered member that is an example of the present invention, and a semiconductor device substrate utilizing this ceramic sintered member, will be explained below in detail.

**Example 1**

A ceramic sintered member of Example 1 of the present invention will be explained below.

The ceramic sintered member of Example 1 is a ceramic sintered member used as an insulator used for a power module used in electronic equipment such as that of an automobile, air conditioner, industrial robot, service elevator, domestic microwave oven, induction heated electric rice cooker, electricity generation or transmission (wind electrical power generation, solar photoelectrical power generation, fuel cells, or the like), electrical powered railway, UPS (uninterruptible power supply), or the like.

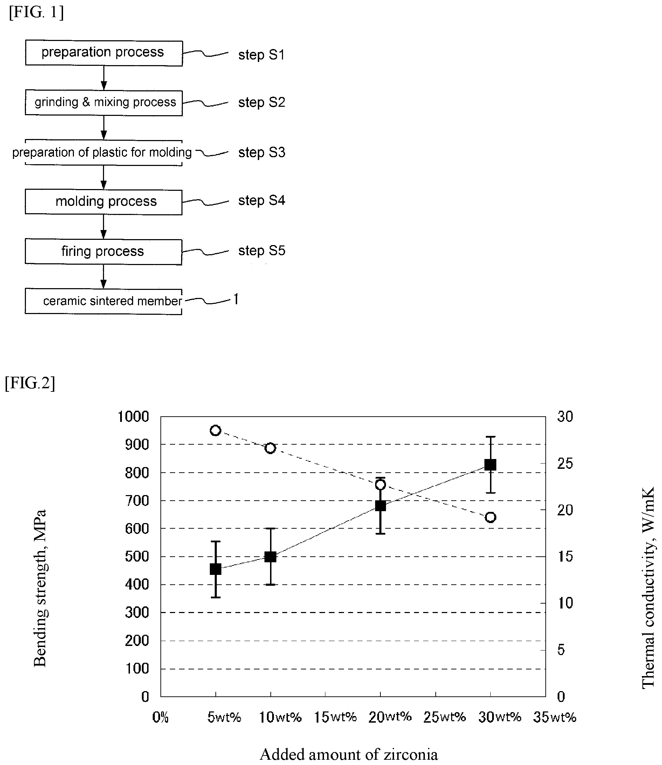

Firstly, the method of production of the ceramic sintered member of Example 1 will be explained in detail while referring to FIG. 1.

FIG. 1 is a flowchart showing the method of production of the ceramic sintered member of Example 1.

As shown in FIG. 1, during production of the ceramic sintered member of Example 1, firstly the alumina, partially stabilized zirconia, and magnesia are prepared at the proportions indicated, for example, in the below listed Table 1 for the powder material (step S1). Then the prepared powder material is ground and blended (step S2), for example, using a ball mill or the like. Thereafter, to this blended material are added an organic binder (such as polyvinyl butyral (PVB) or the like), a solvent (such as xylene, toluene, or the like), and a plasticizer (such as dioctyl phthalate (DOP)) to form a slurry (step S3).

[Table 1]

| Powder material | Content (wt%, taking the total amount of powder material as 100 wt%) | Comments |
| --- | --- | --- |
| alumina | 77.8 (wt%) | -- |
| partially stabilized zirconia | 21.95 (wt%) | upper limiting value = 30 (wt%) |
| magnesia | 0.25 (wt%) | within the range of 0.05 to 0.5 (wt%) |

FIG. 2 is a graph showing the change of bending strength and thermal conductivity as the added amount of partially stabilized zirconia is changed during production of the ceramic sintered member of Example 1. Within this graph, the black square symbols indicate bending strength, and the white circle symbols indicate thermal conductivity.

As shown in FIG. 2, during production of the ceramic sintered member 1 of Example 1, the bending strength (mechanical strength) of the ceramic sintered member 1 after sintering increases as the content of the partially stabilized zirconia increases, and there is a decrease of thermal conductivity, which is an indicator of heat dissipation, when the ceramic sintered member is used as a power module substrate. For this reason, during production of the ceramic sintered member 1 of Example 1, the upper limit of the content of the partially stabilized zirconia relative to the total amount of the powder material is set at 30 percent by weight. Moreover, although an improvement effect of mechanical strength of the ceramic sintered member 1 is achieved if the content of the partially stabilized zirconia in the total powder material is at least 1 percent by weight, in order to cause a sufficient improvement of this mechanical strength, the content of the zirconia in the total powder material is preferably greater than or equal to 5 percent by weight.

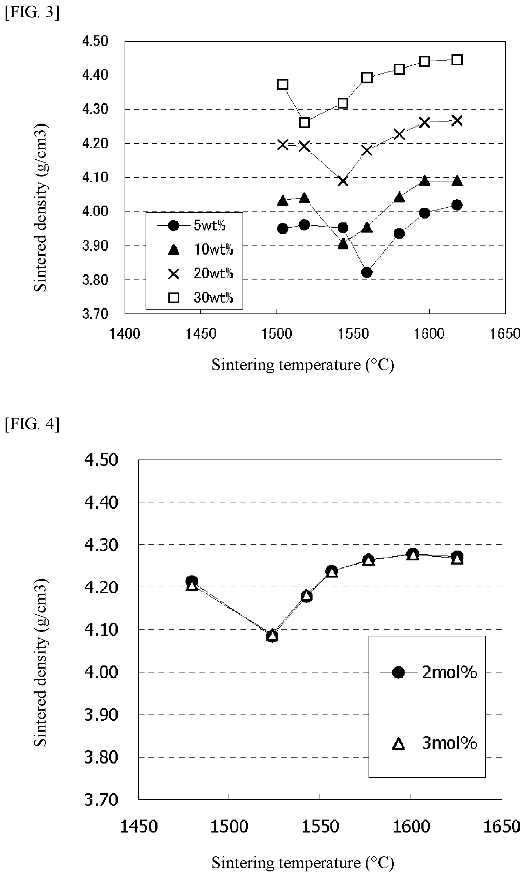

FIG. 3 is a graph showing the relationship between sintering temperature and sintered density while the added amount of partially stabilized zirconia is changed during production of the ceramic sintered member of Example 1. Here, sintered density (apparent density) was measured using the Archimedes method.

As shown in FIG. 3, as the sintering temperature was raised, the sintered density displayed a tendency to greatly decrease and then to rise again. That is, in the temperature region where there is a big drop in the sintered density, sintering of the ceramic sintered member is in an activating state. Then thereafter, the temperature region where a large change in sintered density doesn't occur is the appropriate sintering temperature for stable sintering.

As made clear by FIG. 3, it is possible to lower the suitable sintering temperature due to the increase of content of the partially stabilized zirconia included in the powder material.

FIG. 4 is a graph showing the relationship between sintering temperature and sintered density while changing the mole fraction of yttria in the partially stabilized zirconia included in the powder material. Furthermore, sintered density (apparent density) was measured here using the Archimedes method.

As shown in FIG. 4, when the mole fraction $M_{Y2O3}$ ($M_{Y2O3} = (m_{Y2O3}/(m_{Zr03} + m_{Y2O3}))$, where $m_{Y2O3}$ is the amount of yttria, and $m_{Zr02}$ is the amount of zirconia) of yttria in the partially stabilized zirconia was either 0.020 or 0.030, sintered density was stabilized at a sintering temperature below 1,600°C.

Therefore, by setting the mole fraction of yttria in the partially stabilized zirconia included in the powder material in the range of about 0.015 to 0.035, it is possible to lower the sintering temperature of the ceramic sintered member 1 of Example 1 below 1,600°C.

Furthermore, the partially stabilized zirconia used as a powder material during production of the ceramic sintered member 1 of Example 1 preferably has high quality and is produced by a method such as the neutralization-coprecipitation method, hydrolysis method, alkoxide method, or the like. This partially stabilized zirconia preferably is a powder that has a small average particle size.

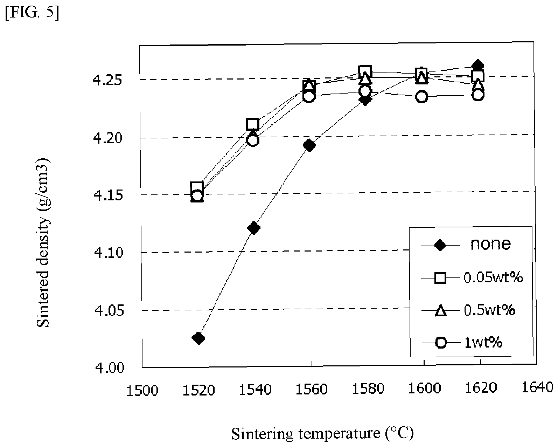

FIG. 5 is a graph showing the relationship between sintering temperature and sintered density while changing the added amount of magnesia during production of the ceramic sintered member of Example 1. Here, sintered density (apparent density) was measured using the Archimedes method.

As shown in FIG. 5, although the temperature region of stabilization of sintered density was greater than or equal to 1,600°C when magnesia was not added to the powder material, the sintered density was stabilized at about 1,560°C whenever the powder material included magnesia.

Therefore, it is possible to lower temperature of sintering of the ceramic sintered member 1 by including magnesia in the powder material. More specifically, the sintering temperature of the ceramic sintered member 1 of Example 1 could be lowered below 1,600°C. Moreover, the sintering temperature lowering effect was realized simply by including 0.05 percent by weight of magnesia in the total amount of powder material.

On the other hand, when the added amount of magnesia relative to the total amount of the powder material exceeded 0.50 percent by weight, a trend was found for sintered density to decrease at all sintering temperatures. This lowering is thought to be due to an increase in the proportion of spinel crystals, which have a low specific gravity (specific gravity reference values are 4.0 for alumina, 6.1 for zirconia, and 3.6 for spinal crystal). Excessive generation of spinal crystals is undesirable due to lowering of heat dissipation ability of the ceramic sintered member. Therefore, the content of magnesia in the total amount of the powder material was set within the range of 0.05 to 0.50 percent by weight during production of the ceramic sintered member 1 of Example 1.

Returning again to FIG. 1, the slurry prepared during step S3 was molded into a desired shape by a desired means for molding, such as mold pressing, cold hydrostatic pressing, injection molding, doctor blade processing, extrusion molding, or the like (step S4). The doctor blade method, in particular, was used for the production of the ceramic sintered member 1 of Example 1.

After this step, the ceramic molded body produced by the above listed types of steps was sintered, for example, in an oxygen ($O_2$) atmosphere or in air, and at a temperature below 1,600°C (step S5).

Multiple ceramic moldings molded into sheets were stacked with top dressing between the moldings and were simultaneously sintered during this sintering process of step S5. During this sintering, the top dressing had the effect of preventing the sintered sheet-like ceramic sintered members from fusing and becoming attached together. The alumina used as the top dressing was the same alumina used for the powder material and, therefore, the top dressing had no particular effect on the ceramic sintered member 1 even when part of the top dressing fused and became attached to the surface of the ceramic sintered member 1.

A comparison between characteristic values of the ceramic sintered member 1 of Example 1 produced by steps such as those described previously and the ceramic sintered member of the Conventional Example is shown below in Table 2. Furthermore, the Conventional Example used for comparison in the below listed Table 2 was the ceramic sintered member disclosed in Patent Citation 1.

Furthermore, for measurement of the characteristic values shown in Table 2, the powder material blended at the proportions shown in the previous Table 1 for the ceramic sintered member 1 of Example 1 was used for the ceramic sintered member 1 sintered at 1,560°C.

[Table 2]

| Item | Units | Conventional example (ceramic sintered member disclosed in Patent Citation 1) | Invention product (ceramic sintered member of Example 1) |
|---|---|---|---|
| sintering temperature | °C | 1625 | 1560 |
| Xt value*1 | % | 40 | 97 |
| alumina crystal average grain size | μm | 1.5 - 7.0 | 1.0 - 3.0 |
| zirconia crystal average grain size | μm | 1.0 - 3.5 | 0.1 - 1.5 |
| bending strength | MPa | 520 | 660 - 700 |
| sintered density | g/cm$^3$ | 4.24 | 4.27 |
| thermal conductivity | W/m·K | 22 | 24 |
| thermal expansion coefficient | ppm/K | 7.29 | 8.41 |
| *1: This was calculated by the modified (1) Garvie and Nicholson formula using integrated intensities for each reflection measured by x-ray diffraction. <br> *2: | | | |

$$Xt = \left[ 1 - \left\{ \frac{Im(1\,1\,1) + Im(1\,1\,\overline{1})}{Im(1\,1\,1) + Im(1\,1\,\overline{1}) + It(1\,1\,1)} \right\} \right] \times 100 \quad \cdots (1)$$

Here, Xt for the above listed Equation (1) indicates mole fraction, indicated as a percentage by multiplication by 100, of the tetragonal phase in the zirconia crystal grains within the ceramic sintered member. I is taken to mean the integrated intensity of each reflection, m is taken to be the monoclinic phase, and t is taken to mean the tetragonal phase.

As shown in the above listed Table 2, the ceramic sintered member 1 of Example 1 included partially stabilized zirconia and also magnesia as essential constituents of the powder material during the manufacture of the ceramic sintered member and, thus, it was possible to lowering the sintering temperature of the ceramic sintered member 1 to a temperature below 1,600°C.

When the sintering temperature of the ceramic sintered member 1 of Example 1 is lower than 1,600°C during the sintering process of step S5, it is possible to suppress roughening of the surface of the sintered ceramic sintered member 1 that occurs due to fusion, attachment, and incorporation of powder-like alumina (which is provided interposed between the ceramic moldings, e.g. ceramic green sheets) into the surface of the ceramic sintered member 1. By this means, when copper plate or aluminum plate is attached to the surface of the ceramic sintered member 1 of Example 1 to form a DBOC substrate or DBOA substrate, it is possible to reduce the occurrence of voids at the interface between the ceramic sintered member 1 and the metal plate (copper plate or aluminum plate) (effect 1).

Moreover, due to lowering of the temperature of sintering of the ceramic sintered member 1 of Example 1, as shown in the above listed Table 2, it is possible to suppress swelling growth of the zirconia grains and alumina crystal grains within the ceramic sintered member 1 after sintering. More specifically, in addition to reducing the average size of the alumina crystals by about 43 to 67 percent of the conventional size, it is possible to reduce the average size of the zirconia crystal by about 10 to 42 percent of the conventional size. When zirconia crystal grains are large within the ceramic sintered member 1, wettability of the Cu-O eutectic phase declines during attachment of the copper plate to the surface of the ceramic sintered member, and this results in loss of product quality due to the resultant high generation rate of voids. In contrast, sintering can be completed for the ceramic sintered member 1 of Example 1 while maintaining a small average size of the zirconia crystal grains within the sintered ceramic sintered member 1. More specifically, it is possible to produce average particle size of the zirconia crystals within the ceramic sintered member 1 of Example 1 within the range of 0.1 to 1.5 $\mu$m and, thus, it is possible to greatly improve wettability of the Cu-O eutectic phase at the surface of the ceramic sintered member 1 of Example 1. This result is able to decrease the generation rate of voids during attachment of copper plate to the surface of the ceramic sintered member 1 of Example 1 (effect 2).

Furthermore, by lowering the sintering temperature by including magnesia and partially stabilized zirconia in the powder material, it is possible to form the sintered ceramic sintered member 1 as a densely sintered member. As a result, it is possible to greatly increase sintered density. As a result as shown in Table 2, thermal conductivity of the ceramic sintered member 1 of Example 1 can be increased by about 8 percent in comparison to the Conventional Example. By this means, it is possible to increase heat dissipation of the ceramic sintered member 1 of Example 1 in comparison to the Conventional Example (effect 3).

Furthermore, partially stabilized zirconia is used as a powder material for the ceramic sintered member 1 of Example 1 and, thus, it is possible to produce 80 to 100 percent of the zirconia crystals in the sintered ceramic sintered member 1 in the tetragonal phase (see the above listed Table 2).

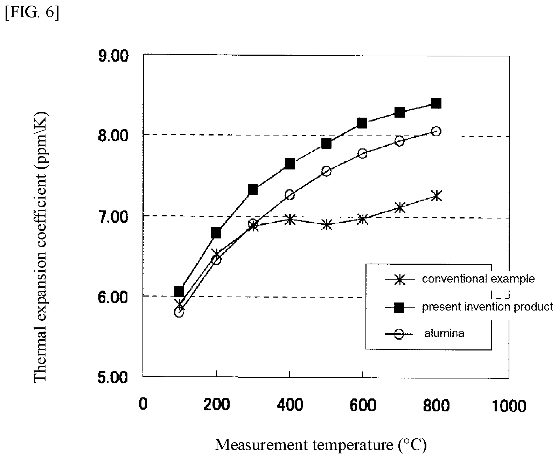

FIG. 6 is a graph showing the change of thermal expansion coefficient as temperature is raised for a ceramic formed from just alumina, for the ceramic sintered member of a conventional example, and for the ceramic sintered member according to Example 1. Within FIG. 6, the "conventional example" is the ceramic sintered member disclosed in Patent Citation 1, and the "invention product" is the ceramic sintered member 1 of Example 1 of the present invention. Furthermore, data for a zirconia-free ceramic sintered member formed only from alumina is included for comparison.

When the temperature of the ceramic sintered member of the Conventional Example was raised in a range of 100°C to 800°C, thermal expansion coefficient of the ceramic sintered member didn't greatly exceed 7.00 (ppm/K). In contrast, the ceramic sintered member formed from alumina and the ceramic sintered member 1 of Example 1 had increased thermal expansion coefficients as the temperature was raised. In particular, the thermal expansion coefficient of the ceramic sintered member 1 of Example 1 increased to 8.0 to 9.0 (ppm/K).

Due to the proportion of the tetragonal phase of zirconia crystals in the ceramic sintered member being less than or equal to 50 percent in the ceramic sintered member of the Conventional Example, the monoclinic phase zirconia crystals readily undergo phase transition to the tetragonal phase when temperature of the Conventional Example ceramic sintered member is raised. It is then difficult, due to the occurrence of shrinkage of the volume of the zirconia crystals, to increase the thermal expansion coefficient of the Conventional Example ceramic sintered member.

Therefore, when copper plate or aluminum plate is attached to the surface of the Conventional Example ceramic sintered member, the thermal expansion coefficient differential between the ceramic sintered member and the metal plate becomes large as the temperature of the ceramic sintered member is raised. Therefore, thermal stress at the interface between the ceramic sintered member and the metal plate increases, finally resulting in the readily occurrence of flaking and separation of the metal plate from the ceramic sintered member. It has been difficult for this reason to produce a large sized DBOC or DBOA substrate with high mechanical reliability using the Conventional Example ceramic sintered member.

In contrast, the ceramic sintered member 1 of Example 1 has 80 to 100 percent of the zirconia crystal grains in the ceramic sintered member in the tetragonal form, and almost none of the monoclinic phase is included in the zirconia crystal grains within the ceramic sintered member, so that the above described type of phase transition hardly occurs. Therefore, reduction of volume of the zirconia crystal grains in the ceramic sintered member 1 of Example 1 does not occur, and the thermal expansion coefficient increases as temperature is raised.

As a result, when the ceramic sintered member 1 of Example 1 is subjected to thermal cycling, it is possible to suppress the accumulation of defects that result from reduction of volume of zirconia crystal grains within the ceramic sintered member 1. Thus, it is possible to increase mechanical reliability of the product. In addition, due to favorable increase of the thermal expansion coefficient when the copper or aluminum plate is attached to the surface, it is possible to alleviate thermal stress generated at the interface between the ceramic sintered member surface and the metal plate when the temperature of the ceramic sintered member 1 of Example 1 is raised. From this standpoint, it is possible to increase mechanical reliability when using the ceramic sintered member 1 of Example 1 in a product (effect 4).

In this case, due to the improvement of yield of the product using the ceramic sintered member 1 of Example 1, it is possible to increase productivity of the product using the ceramic sintered member 1 of Example 1 (effect 5).

Furthermore, when the proportion of the tetragonal phase in the zirconia crystals within the ceramic sintered member approaches 100 percent as in the ceramic sintered member 1 of Example 1, the bending resistance (mechanical strength) of the ceramic sintered member 1 also increases. This results in the possibility of producing a large sized DBOC substrate or DBOA substrate (effect 6).

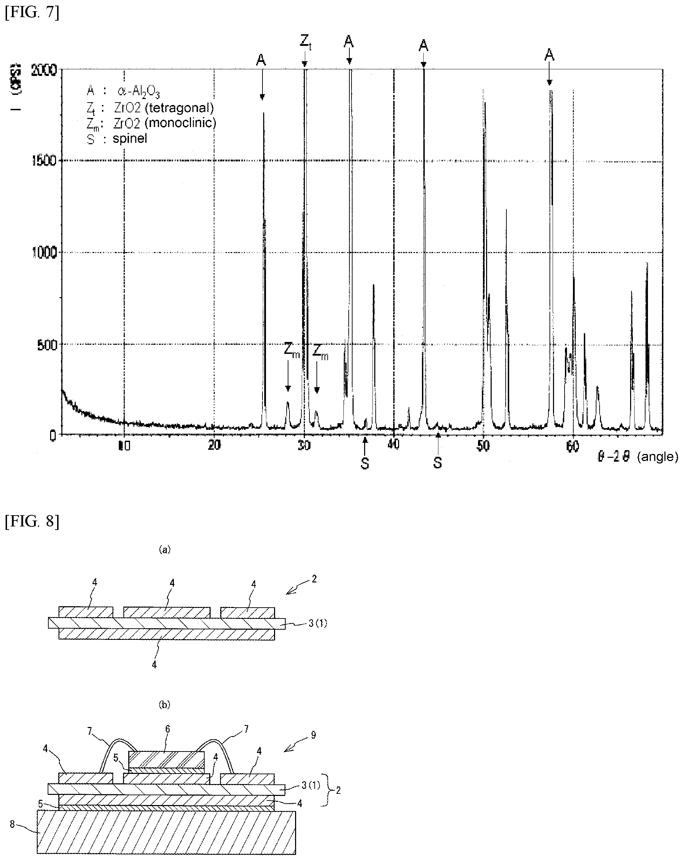

FIG. 7 shows results (an x-ray diffraction chart) of x-ray diffraction measurement of the crystal structure of the ceramic sintered member according to Example 1.

As shown in FIG. 7, due to the inclusion of magnesia as an essential constituent ingredient in the powder material, spinel crystals ($MgO\text{-}Al_2O_3$) could be generated in the sintered ceramic sintered member 1 of Example 1.

Due to the existence of these spinel crystals, it was possible to increase wettability of the Cu-O eutectic phase during attachment of the copper plate to the surface of the ceramic sintered member 1 of Example 1 (effect 7).

On the other hand, when the content of the spinel crystals within the ceramic sintered member 1 is high, thermal conductivity of the ceramic sintered member 1 of Example 1 is lowered. Therefore, by taking these points into account, the content of magnesia in the total powder material of Example 1 is set within the range of 0.05 to 0.50 percent by weight.

Furthermore, including magnesia in the powder material has the effect of increasing grain interfacial strength of the alumina crystal grains and zirconia crystal grains within the ceramic sintered member 1 of Example 1 (this is apparent from the fact that bending strength of Example 1 is higher than bending strength of the Conventional Example in Table 2). As a result from this standpoint, it is possible to increase mechanical reliability when the ceramic sintered member 1 of Example 1 is used for the production of a DBOC or DBOA substrate (effect 8).

Furthermore, results of verification testing concerning the void generation prevention effect (prevention of partial flaking or separation of the copper, due to generation of spinel crystals within the ceramic sintered member 1 of Example 1) will be explained in detail in the following paragraphs during use of the ceramic sintered member 1 as a DBOC substrate.

Methods that can be considered for including spinel crystals in the ceramic sintered member 1 of the ceramic sintered member 1 of Example 1 include: a method of generating spinel crystals at the time of sintering by including alumina and magnesia in the powder material (method 1: method of the invention of the present application), and a method of directly including spinel crystals in the powder material without including magnesia as an essential constituent ingredient in the powder material (method 2: method disclosed in Patent Citation 4).

Generally, magnesia (MgO) absorbs moisture and carbon dioxide when left in the air and gradually forms magnesium hydroxide. Moreover, magnesia generates heat when dissolved in a slight amount of water, and magnesia has the property of forming magnesium hydroxide (see the "Dictionary of Physics and Chemistry, vol. 5, published by Iwanami Shoten, Publishers). In addition, magnesia is clearly mentioned in various types of non-patent references as being reactive with water or carbon dioxide.

In contrast, no mention is found of spinel ($MgO\text{-}Al_2O_3$) being reactive with water or carbon dioxide in this manner (for example, see the Ceramic Dictionary, 2nd Edition, edited by The Ceramic Society of Japan). Therefore, where comparing magnesia and spinel, magnesia is assumed to be more chemically active. In other words, spinel can be said to be more chemically stable than magnesia.

For this reason, during the production of the ceramic sintered member 1 of Example 1, the addition of magnesia alone, rather than the addition of spinel as a powder material, is thought to promote the sintering of alumina due to the reaction of formation of spinel. In addition, magnesia forms a solid solution in zirconia during sintering and is thought to also induce the zirconia sintering.

That is, during use of the ceramic sintered member 1 of Example 1 as a DBOC substrate, the generation of voids at the bonding interface with the copper must be efficiently prevented. Spinel must be included in the ceramic sintered member 1 in order to achieve this goal.

In order to manufacture the ceramic sintered member 1 that includes spinel, the method of adding spinel alone to the powder material (method 2: the method disclosed in Patent Citation 4) and the method of adding magnesia alone to the powder material (method 1: the method of the invention of the present application) can be considered. The latter method, in particular, can be anticipated to have a spinel formation reaction effect (effect i) and solid solution reaction of magnesia in zirconia (effect ii).

Moreover, both of the above mentioned effects i and ii are thought to contribute to a lowering of sintering temperature during production of the ceramic sintered member 1 of Example 1. That is, it is possible to reduce cost of production during manufacture of the ceramic sintered member 1 of Example 1.

Therefore, the method of adding magnesia alone to the powder material and causing generation of spinel within the ceramic sintered member 1 during sintering is adopted for the present example.

Although alumina ceramics (i.e. ceramics having alumina as the major ingredient) are known to be superior for properties such as high strength, wear resistance, corrosion resistance (properties listed in order of descending degree of superiority), zirconia ceramics (i.e. ceramics having zirconia as the major ingredient) are known to be superior for properties such as high toughness, high strength, and wear resistance (properties listed in order of descending degree of superiority).

The ceramic sintered member disclosed in Patent Citation 4 uses partially stabilized zirconia as the main ingredient and uses alumina as a secondary ingredient. Therefore, the ceramic sintered member is characterized in that strength is readily affected by partial stabilization agent of the zirconia. Moreover, according to the invention disclosed in Patent Citation 4, there is a need to prevent of deterioration over time of the ceramic sintered member during use at temperatures of 200°C to 400°C, and the technology for providing a solution to this problem selects a partial stabilization agent and has a characteristic sintering method for the ceramic sintered member.

In contrast, the ceramic sintered member 1 of the present example is used for a DBOC substrate or a DBOA substrate (i.e. for a power module) that is used at a temperature, i.e. a maximum of about 150°C for a silicon device, which is far lower than the 200°C to 400°C where deterioration becomes a problem for zirconium that has been stabilized using yttria. Furthermore, in the ceramic sintered member 1 of Example 1 of the present invention, alumina is used as the main ingredient of the power material used for production of the ceramic sintered member, and partially stabilized zirconia is used as a secondary ingredient that is stabilized only by yttria. Therefore, internal structure of the ceramic sintered member 1 after sintering becomes that of a sintered composition in which a small amount of zirconia grains are dispersed in alumina. Thus, when heat acts on the ceramic sintered member of Example 1, even though volume expansion occurs at the surface due to phase change of the zirconia grains, it is thought that the effect of such expansion is limited. For these reasons, the problem of deterioration over time does not become manifest for the ceramic sintered member 1 of Example 1.

For this reason, the ceramic sintered member 1 of the present example uses the atmospheric pressure sintering method, which is advantageous (inexpensive) from the standpoint of production cost, and there is no need whatsoever to adopt the hot press method or the hot hydrostatic press method as in the production of the invention disclosed in Patent Citation 4. Moreover, in the zirconia stabilization agent used in the ceramic sintered member 1 of the present example, ceria (which lowers strength of the ceramic sintered member 1) is not used whatsoever, and only yttria is used.

Therefore, the ceramic sintered member disclosed in Patent Citation 4 and the ceramic sintered member 1 of Example 1 of the present invention solve different problems, and the technical concepts of these ceramic sintered members can be said to be entirely different.

Furthermore, silica ($SiO_2$) may be blended separately with the powder material indicated in the above listed Table 1 in an amount less than or equal to 1 percent by weight relative to the total amount of the powder material. Addition of silica ($SiO_2$) to the powder material has the effect of making possible an increase of wettability of the Cu-O eutectic phase during attachment of the copper plate to the surface of the ceramic sintered member 1 of Example 1, in the same manner as the above mentioned spinel crystals.

When the upper limit of the added amount of silica is set to 1 percent by weight relative to the total amount of the powder material, it is possible to greatly promote the improvement of wettability of the Cu-O eutectic phase with the surface of the ceramic sintered member 1, while having almost no change of thermal conductivity of the ceramic sintered member 1 of Example 1. As a result, it is possible to lower the generation of voids at the interface during attachment of the copper plate to the surface of the ceramic sintered member 1 of Example 1.

Therefore, when silica is added to the powder material in the above described manner, and when the ceramic sintered member 1 of Example 1 is used as a DBOC substrate insulator, it is possible to greatly increase quality. Furthermore, it is possible to increase product productivity due to the improvement of product yield due to this quality increase.

Here, test results concerning the effect of separate addition of silica ($SiO_2$) to the ceramic sintered member 1 of Example 1 will be explained.

Table 3 shows results of measurements of volumetric resistivity when the temperature was at least 300°C temperature and also when the respective samples were at room temperature (25°C), and Table 3 also shows the blended fractions in the powder material in order to produce a ceramic sintered member 1 (sample no. 2) of Example 1 containing blended silica and to produce a ceramic sintered member 1 (sample no. 1) of Example 1 containing no added silica.

Generally, electrical current is known to be proportional to voltage when a DC voltage is applied to an insulator material such as a ceramic or the like. Volumetric resistivity indicates the "difficulty of the flow" of this electrical current. Therefore, a material being tested can be said to more excellent as an insulator material as volumetric resistivity of the material being tested increases.

[Table 3]

| | Powder material (wt%) | | | | | | Volumetric resistivity ($\Omega$ cm) | | | | |
|---|---|---|---|---|---|---|---|---|---|---|---|
| | $Al_2O_3$ | $ZrO_2$ | $Y_2O_3$ | PSZ | MgO | $SiO_2$ | 25°C | 300°C | 500°C | 700°C | Sintering temp. |
| Comparative Example | 77.2 | 22.0 | 0.75 | | | | >$1.0\times10^{14}$ | $5.2\times10^9$ | $6.9\times10^6$ | $1.4\times10^5$ | 1625°C |
| sample no. 1 | 77.8 | | | 21.95 | 0.25 | | >$1.0\times10^{14}$ | $1.3\times10^8$ | $5.2\times10^5$ | $2.0\times10^4$ | below 1600°C |
| sample no. 2 | 77.3 | | | 21.95 | 0.25 | 0.5 | >$1.0\times10^{14}$ | $3.5\times10^{10}$ | $6.7\times10^7$ | $1.7\times10^6$ | below 1600°C |
| PSZ: partially stabilized zirconia (3.0 mol% yttria) | | | | | | | | | | | |

Volumetric resistivity measurement voltage: DC 10V

The above listed 3 types of samples (i.e. the Comparative Example, sample no. 1, and sample no. 2) were produced according to the procedure indicated previously in FIG. 1 using the three types of powder materials shown in the above listed Table 3. More specifically, a binder was added to the powder material shown in Table 3 to produce a slurry. This slurry was molded to form ceramic green sheets. Thereafter, the ceramic green sheets were sintered under the temperature conditions indicated above in Table 3 to obtain the above listed three types of samples.

As made clear by the above listed Table 3, the ceramic sintered member 1 (sample no. 1) of the Example 1 without added silica was found to tend to have a greatly reduced volumetric resistivity in the temperature environment greater than or equal to 300°C in comparison to the ceramic sintered member 1 (sample no. 2) of Example 1 containing blended silica or the conventional technology ceramic sintered member (Comparative Example).

In contrast, in comparison to the other samples, the ceramic sintered member 1 (sample no. 2) of Example 1 that contained blended silica had the highest volumetric resistivity in the temperature environment greater than or equal to 300°C.

Therefore, from the above described results, it was confirmed that high insulation performance could be maintained under high temperature conditions when the completed ceramic sintered member 1 was used as the substrate for a power module, by addition of silica to the powder material during production of the ceramic sintered member 1 of Example 1.

In comparison to the conventional example ceramic sintered member, the ceramic sintered member 1 of Example 1 in this manner is excellent with respect to the effects indicated by the above described effect 1 through effect 8. The ceramic sintered member 1 of Example 1 can provide a ceramic sintered member that is particularly suitable for the insulator of a DBOC or DBOA substrate.

Example 2

A semiconductor device substrate of Example 2 will be explained below while referring to FIG. 8.

FIG. 8 (a) is a cross-sectional drawing of the semiconductor device substrate according to Example 2, and (b) is a cross-sectional drawing of a semiconductor device using this semiconductor device substrate.

The semiconductor device substrate 2 of Example 2 is equipped with a copper plate 4 on at least part of the front face and backside face of a ceramic substrate 3 formed from the above described ceramic sintered member 1 of Example 1. More specifically, the copper plate 4 having an electrical transmission circuit formed therein is attached to the front face of the flat-shaped ceramic substrate 3. After arrangement of a flat copper plate 4 on the backside face of the ceramic substrate 3, the assembly is heated for about 10 minutes in a nitrogen atmosphere at a temperature of 1,070°C to 1,075°C to generate the Cu-O eutectic phase at the interface between the copper plate 4 and the ceramic substrate 3 and to wet the surface of the ceramic substrate 3. Thereafter, the assembly is cooled and solidified to bond together the ceramic substrate 3 and the copper plates 4.

The semiconductor device substrate 2 of Example 2 in this manner uses the ceramic sintered member 1 of Example 1 that has characteristics suitable for a DBOC or DBOA substrate as described previously. Therefore, mechanical strength and heat dissipation ability are high, and it is possible to provide a large sized DBOC or DBOA substrate that has high quality. Moreover, as per the results of use of the ceramic sintered member 1 of Example 1, as mentioned previously, for the semiconductor device substrate 2 of Example 2, product yield is improved, and there is an effect of increasing productivity of the product.

Furthermore, in FIG. 8 an example was cited of the attachment of a copper plate 4 having an electrical transmission circuit formed therein. However, the electrical transmission circuit on the ceramic substrate 3 can be formed by a subtractive method or additive method.

Moreover, when providing the aluminum plate on the surface of the ceramic substrate 3, the electrical transmission circuit constituted by aluminum, for example, may be attached to the ceramic substrate 3 through a bonding material. Due to aluminum being more flexible than copper, it is possible to anticipate that thermal stress will be alleviated more than when a copper plate is used. Thus, it is possible to provide a substrate for use in a highly reliable power module.

Then as shown in FIG. 8 (b), a semiconductor chip 6 is carried out the top face side of the semiconductor device substrate 2 of Example 2 with a bonding material 5 therebetween. The circuit formed by the copper plate 4 and this semiconductor chip 6 are connected electrically using bonding wires 7. Furthermore, the semiconductor device 9 is equipped with a heat sink 8 formed from copper plate attached via the bonding material 5 onto a copper plate 5 attached to the bottom face of the semiconductor device substrate 2.

The semiconductor device 9 of Example 2, as shown in FIG. 8 (b), is equipped with the semiconductor device substrate 2 formed from the ceramic sintered member 1 of Example 1 and, thus, mechanical strength and heat dissipation are excellent in comparison to the conventional semiconductor device. Furthermore, this has the effect of making it possible to provide a semiconductor device that has high mechanical reliability and high quality. Moreover, as productivity of the semiconductor device substrate 2 of Example 2 improves, it is possible to also improve productivity of the semiconductor device 9.

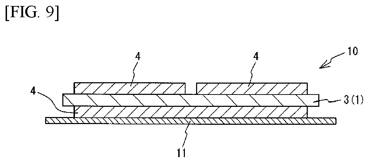

Here, the evaluation test, and results thereof, for verification of the void generation prevention effect during production of the semiconductor device substrate 2 of Example 2 using the ceramic sintered member 1 of Example 1, will be explained while referring to FIG. 9, Table 4, and Table 5.

Firstly, the sample production method used for the evaluation test will be explained while referring to FIG. 9. FIG. 9 is a cross-sectional drawing showing sample arrangement during manufacture of the semiconductor device substrate sample. Parts that are the same as those of FIG. 1 through FIG. 8 are assigned the same reference numerals, and the explanation of such parts will be omitted.

The semiconductor device substrate sample 10 used for this evaluation test was produced by the below described procedure. The method of production of the ceramic sintered member 1 for the semiconductor device substrate sample 10 was the same as that mentioned in Example 1, so explanation of the details of the procedure for such production will be omitted.

Firstly, a 0.25 mm thick copper plate 4 was heated by itself in air at a temperature of 300°C, and surface of the copper plate 4 was oxidized.

Thereafter as shown in FIG. 9, the ceramic sintered member 1 (0.25 mm thick) of Example 1 shown previously in Table 2 was placed on a molybdenum (Mo) mesh material 11 with the oxidation-treated copper plates 4 therebetween. In a nitrogen ($N_2$) atmosphere, the assembly was heated at 1,070°C to produce the semiconductor device substrate sample 10 in a manner similar to that of the semiconductor device substrate 2 indicated in the previously mentioned FIG. 8 (a).

Then to evaluate the degree of void generation, this semiconductor device substrate sample 10 was immersed in water, and the bonding surface between the copper plate 4 and the ceramic sintered member 1 was observed by ultrasonic microscopy.

More specifically, the convention technology type semiconductor device substrate (semiconductor device substrate using the ceramic sintered member disclosed in Patent Citation 1) and the semiconductor device substrate sample 10 of the present invention shown in FIG. 9 were prepared (10 samples each). For all of these samples, voids having a diameter greater than or equal to 1 mm (i.e. voids considered to particularly affect heat dissipation when the ceramic sintered member is used as a DBOC substrate) were counted to determine the average void count. The respective average values are shown below in Table 4.

[Table 4]

| | Conventional Example (semiconductor device substrate using the ceramic sintered member disclosed in Patent Citation 1) | Present Invention Product (semiconductor device substrate using the ceramic sintered member of Example 1) |
|---|---|---|
| no. of samples used for evaluation | 10 samples | 10 samples |
| no. of voids greater than or equal to 1 mm in diameter (no./sample) | front: 4.8<br>backside: 8.0 | front: 1.8<br>backside: 1.2 |

As shown in Table 4 above, when the semiconductor device substrate sample 10 using the ceramic sintered member 1 of Example 1 was produced, the generation of voids greater than or equal to 1 mm in size was found to be greatly suppressed on both the front face and backside face of the semiconductor device substrate 2 of Example 2 (semiconductor device substrate sample 10).

[Table 5]

| | Conventional Example | Present Invention Product |
|---|---|---|
| front copper plate - ceramic substrate bonding interface | | |
| backside copper plate - ceramic substrate bonding interface | | |

Moreover, the above listed Table 5 shows images taken through the ultrasonic microscope for both the front face and backside face of the Conventional Example and the Present Invention Product. The white round spots within the above Table 5 are voids. It is possible to visually confirm that the Present Invention Product had few voids in comparison to the Conventional Example.

**Possibility of Industrial Use**

As explained previously, the present invention has excellent heat dissipation and high mechanical strength in comparison to the conventional product. Furthermore, the high quality ceramic sintered member is resistant to the generation of voids during attachment of a metal plate such as a copper plate or the like. This ceramic sintered member and the semiconductor device substrate utilizing the ceramic sintered member can be used in the field of electronics for automobiles, air conditioning equipment, industrial robots, service elevators, domestic microwave ovens, induction heated rice cookers, electrical power generation and electrical power transmission (wind power generation, solar power generation, fuel cells, or the like), electrically powered trains, uninterruptable power supplies (UPS), or the like.

**Claims**

1. A ceramic sintered member, wherein
a powder material used during production of the ceramic sintered member consisting of alumina as a main ingredient and partially stabilized zirconia and magnesia as subsidiary ingredients;
content of the partially stabilized zirconia being 1 to 30 percent by weight relative to the entire powder material;
content of the magnesia relative to the entire powder material being within a range 0.05 to 0.50 percent by weight;
mole fraction of yttria in the partially stabilized zirconia being within a range of 0.015 to 0.035;
and 80 to 100 percent of the zirconia crystals included in the ceramic sintered member being in the tetragonal crystal phase.

2. The ceramic sintered member according to claim 1; wherein average particle size of the zirconia crystals in the ceramic sintered member is in a range of 0.1 to 1.5 $\mu$m.

3. A semiconductor mounting substrate comprising the ceramic sintered member according to any one of claims 1 and 2 and a copper or aluminum plate bonded to at least part of the front face and backside face.

**Patentansprüche**

1. Gesintertes Keramikelement, wobei

   ein Pulvermaterial, das während der Herstellung des gesinterten Keramikelements verwendet wird, als Hauptbestandteil aus Tonerde und als Hilfsbestandteile aus teilweise stabilisierter Zirkonerde und Magnesiumoxid besteht;

   der Gehalt der teilweise stabilisierten Zirkonerde zwischen 1 und 30 Gewichtsprozent im Verhältnis zu dem gesamten Pulvermaterial besteht;

   der Gehalt an Magnesiumoxid im Verhältnis zu dem gesamten Pulvermaterial in einem Bereich zwischen 0,05 und 0,50 Gewichtsprozent liegt;

   der Molenbruch von Yttriumoxid in der teilweise stabilisierten Zirkonerde in einem Bereich zwischen 0,015 und 0,035 liegt; und

   sich 80 bis 100 Prozent der Zirkonerdekristalle, die in dem gesinterten Keramikelement enthalten sind, in der tetragonalen Kristallphase befinden.

2. Gesintertes Keramikelement nach Anspruch 1;

   wobei die durchschnittliche Partikelgröße der Zirkonerdekristalle in dem gesinterten Keramikelement in einem Bereich zwischen 0,1 und 1,5 $\mu$m liegt.

3. Halbleiter-Befestigungssubstrat, aufweisend das gesinterte Keramikelement nach einem der Ansprüche 1 und 2 und eine Kupfer- oder Aluminiumplatte, die mit zumindest einem Teil der Vorderfläche und Hinterfläche verbunden ist.


**Revendications**

1. Élément fritté en céramique, dans lequel

   un matériau en poudre utilisé lors de la production de l'élément fritté en céramique constitué d'alumine en tant qu'ingrédient principal, et de zircone partiellement stabilisée et de magnésie en tant qu'ingrédients secondaires ;

   la teneur en zircone partiellement stabilisée étant de 1 à 30 % en poids par rapport à l'ensemble du matériau en poudre ;

   la teneur en magnésie par rapport à l'ensemble du matériau en poudre étant dans une plage de 0,05 à 0,50 % en poids ;

   la fraction molaire d'yttria dans la zircone partiellement stabilisée étant dans une plage de 0,015 à 0,035 ;

   et 80 à 100 % des cristaux de zircone inclus dans l'élément fritté en céramique étant dans la phase cristalline tétragonale.

2. Élément fritté en céramique selon la revendication 1 ;

   dans lequel la taille de particule moyenne des cristaux de zircone dans l'élément fritté en céramique est dans une plage de 0,1 à 1,5 $\mu$m.

3. Substrat de montage de semi-conducteur comprenant l'élément fritté en céramique selon l'une quelconque des revendications 1 et 2 et une plaque de cuivre ou d'aluminium fixée à au moins une partie de la face avant et de la face arrière.

[FIG. 1]

[FIG.2]

Added amount of zirconia

[FIG. 3]

[FIG. 4]

[FIG. 5]

[FIG. 6]

[FIG. 7]

[FIG. 8]

(a)

(b)

[FIG. 9]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1510509 A
- EP H738014 A
- EP H8195450 A
- EP H8195458 A
- EP H6263533 A

**Non-patent literature cited in the description**

- Dictionary of Physics and Chemistry. Iwanami Shoten, vol. 5
- Ceramic Dictionary. The Ceramic Society of Japan